Europäisches Patentamt

European Patent Office

Office européen des brevets

(11) Publication number: **0 328 853**
**A2**

## (12) EUROPEAN PATENT APPLICATION

(21) Application number: 88830196.7

(22) Date of filing: 09.05.88

(51) Int. Cl.⁴: **H05K 7/14** , **H05K 13/00**

(30) Priority: 15.02.88 IT 1941188

(43) Date of publication of application:
**23.08.89 Bulletin 89/34**

(34) Designated Contracting States:
**BE CH DE ES FR GB GR LI NL**

(71) Applicant: **TECNOLOGIE GALVANICHE S.R.L.**
**Via Sardegna, 66**
**I-20090 Fizzonasco Di Pieve Emanuele**
**Milano(IT)**

(72) Inventor: **Santini, Ettore**
**Tecnologie Galvaniche S.r.l. Via Sardegna 66**
**I-20090 Fizzonasco Di Pieve Emanuele Mil(IT)**

(74) Representative: **Cicogna, Franco**
**Ufficio Internazionale Brevetti Dott.Prof.**
**Franco Cicogna Via Visconti di Modrone,**
**14/A**
**I-20122 Milano(IT)**

(54) **Card holding apparatus with card automatic loading and unloading means and card resilient restraining means.**

(57) The present invention relates to an automatically loaded -unloaded card holding frame, provided with means for resiliently restraining cards,which has the main feature of including a pair of supporting members,which are coupled to one another by a presettable length bar.

A plurality of rods are associated with the mentioned bar,said rods being arranged with an adjoining relationship and being provided,at mutually facing edges thereof,with resilient means engaging with edge portions of the cards to removably restrain or hold said cards.

*Fig. 1*

EP 0 328 853 A2

# CARD HOLDING APPARATUS WITH CARD AUTOMATIC LOADING AND UNLOADING MEANS AND CARD RESILIENT RESTRAINING MEANS

## BACKGROUND OF THE INVENTION

The present invention relates to an automatically loaded-unloaded card holding frame provided with means for resiliently restraining or holding cards an aiso relates to an associated card loading-unloading apparatus.

As is known,in the printed board circuit card making process great difficulties are presently encountered for handling the circuit cards to be processed.

Another drawback is that none supporting frame is presently available which has been specifically designed for holding cards having a rational structure and arrangement able of propelry holding the circuit cards.

## SUMMARY OF THE INVENTION

Accordingly,the task of the present invention is to overcome the above mentioned drawbacks,by providing an automatically loaded/unloaded card holder frame which is able of supporting the circuit cards while affording the desired electric contacts,and able of facilitating the card loading/unloading operations.

Within the scope of the above mentioned task, a main object of the present invention is to provide such a card automatic loading/unloading frame or apparatus which is able to properly engaging the circuit cards for properly arranging them in suitable card collecting magazines.

Another object of the present invention is to provide such a card holding frame which prevents undesired materials from depositing on the card supporting elements.

Still another object of the present invention is to provide such a card holding frame which is able of supporting different size cards,with either a vertical loading or a horizontal loading.

Still another object of the present invention is to provide such a card holding frame which can be made starting from easily commercially available elements and materials and which,moreover,is very competitive from a mere economic standpoint.

According to one aspect of the present invention,the above mentioned task and objects,as well as yet another objects,which will become more apparent hereinafter,are achieved by an automatically loaded/unloaded card holding frame,with means for resiliently holding cards,characterized in that said frame comprises a pair of supporting elements,coupled to one another by a presettable length bar,therewith a plurality of adjoining rods are associated,said rods being provided,on mutually facing edges thereof,with resilient means adapted to engage card edge portions for removably restraining or holding said cards.

## BRIEF DESCRIPTION OF THE DRAWINGS

Further characteristics and advantages of the present invention will become more apparent hereinafter from the following detailed description of a preferred,though not exclusive embodiment thereof, being illustrated,by way of an indicative but not limitative example,in the accompanying drawings,in which:

figure 1 is a prespective view schematically illustrating a card holding or supporting frame according to the present invention;

figure 2 is a cross-sectional view taken along the line II-II of figure 1;

figure 3 shows a detail of resilient means included in the card holding frame according to the invention,which consist of a plate spring,in front view;

figure 4 is a side view of the plate spring;

figure 5 schematically shows plate springs holdin a card;

figure 6 is a cross-sectional view illustrating a fixing arrangement for the plate spring;

figure 7 schematically shows a card holding frame;

figure 8 is a cross-sectional view taken along the line VIII-VIII of figure 7;

figure 9 illustrates a detail of resilient means consisting of a loop spring;

figure 10 shows a loop spring locking a card;

figure 11 shows a cross-sectional view of a detail of fixing means for the loop spring;

figure 12 shows a card holding or supporting frame;

figure 13 is a cross-sectional view taken along the line XIII-XIII of figure 11;

figure 14 is a cross-sectional view taken along the line XIV-XIV of figure 12;

figure 15 is a top plan view illustrating the arrangement of a card loading/unloading apparatus associated with the card holding frame according to the present invention;

figure 16 is a cross-sectional view taken along the line XVI-XVI of figure 15; and

figure 17 is an elevation view illustrating the loading/unloading apparatus associated with the card holding or supporting frame according to the invention.

## DESCRIPTION OF THE PREFERRED EMBODIMENTS

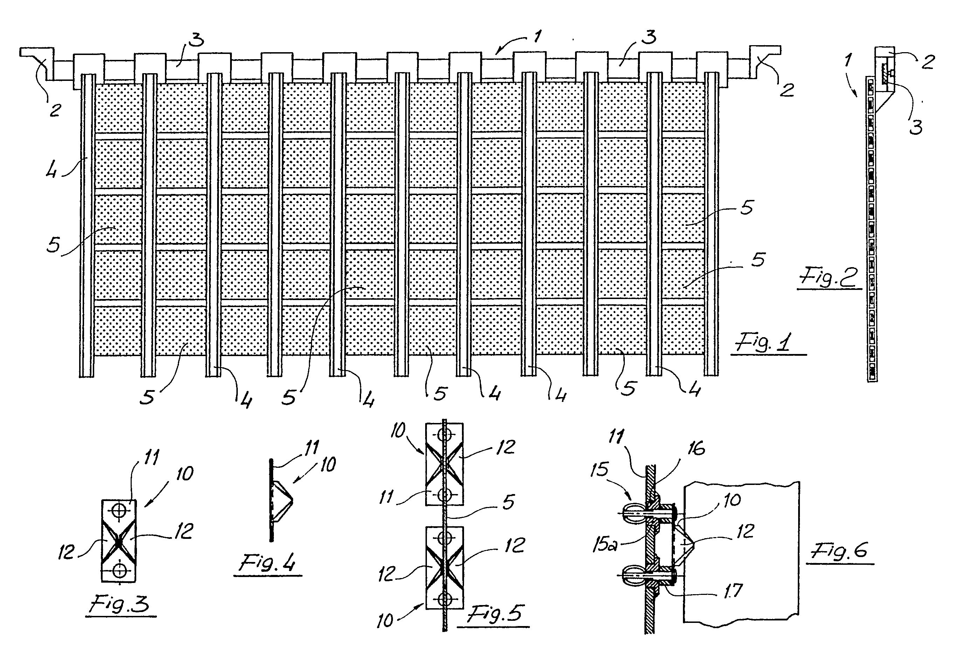

With reference to the mentioned figures of the accompanying drawings,and,more specifically,to figures 1 to 6,a card holding or supporting frame according to the present invention is herein shown, indicated at the reference number 1,which substantially comprises a pair of end supporting elements 2, which are coupled to one another by a bar 3 which may have any suitable length.

The supporting elements 2 and the bar 3 are advantageously made of a not ferrous material and they must be able of conducting electric current.

On the bar 3 there are transversely arranged a plurality of substantially vertically extending rods 4 which are spaced from one another with a substantially adjoining relationship.

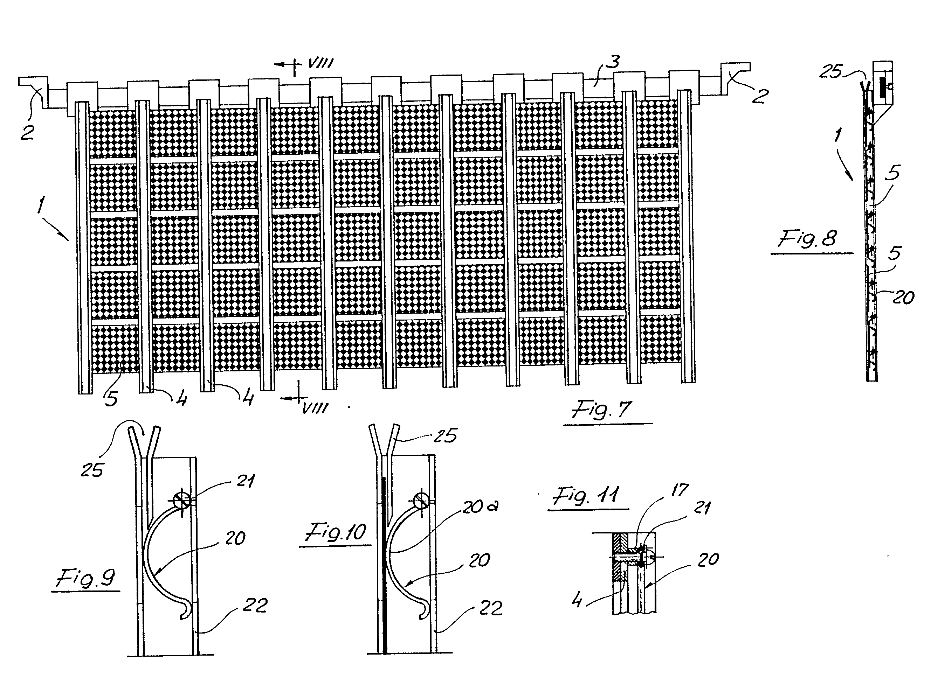

In the embodiment being disclosed,which is illustrated in figures 1 to 6,the resilient means consist of a plate spring 10,which is provided with a base 11 coupled to the mentioned rods 4,therefrom resilient ear members 12 extend,which are arranged with an opposite relationship,and therebetween a card 5 can be inserted and held,as is schematically shown in figure 5.

The base 11 of the spring 10 is held by the rods 4,by means of resilient contact elements 15,which are engaged in throughgoing bushes 16 welded on the rods 4.

Between the base 10 and bushes 16 there are arranged soft PVC spacer members,which has been indicated at 17.

The springs and resilient contact elements are coupled or bound by brazing.The bound components are coated by an insulating material,with the exception of the stems 15a of the resilient contact elements 15 and the abutting points of the ear elements 12 of the plate springs.

The assembled and coated spring is mounted with the interposition of the resilient insulating spacer elements 17.

The mentioned bushes form an integrating part of the rods 4 and are also completely coated by an insulating material,with the exception of the hole therein is engaged the stem portion 15a of the contact element 15.

The resilient contact element is provided for supplying electric current to the spring as well as for compressing the insulating resilient spacer elements so as to seal the assembly.

This arrangement prevent undesired materials from depositing on the rods and,moreover,greatly simplify the stripping operations,since the spring can be easily disassembled so as to remove only the springs but not the completed rods.

In the embodiment shown in figures 7 to 11, the resilient means consist of loop springs 20 which, at one end thereof,are coupled, through a screw 21,to the rods 4,with the interposition of the spacer element indicated at 17.

At the other end thereof,the loop spring engages with an edge or rim 22, defined by the rod,while,at its middle portion,indicated at 20a,the spring engages by contact with the cards which can be inserted onto the rods,by insertion or mounting guides indicated gene rally at 25.

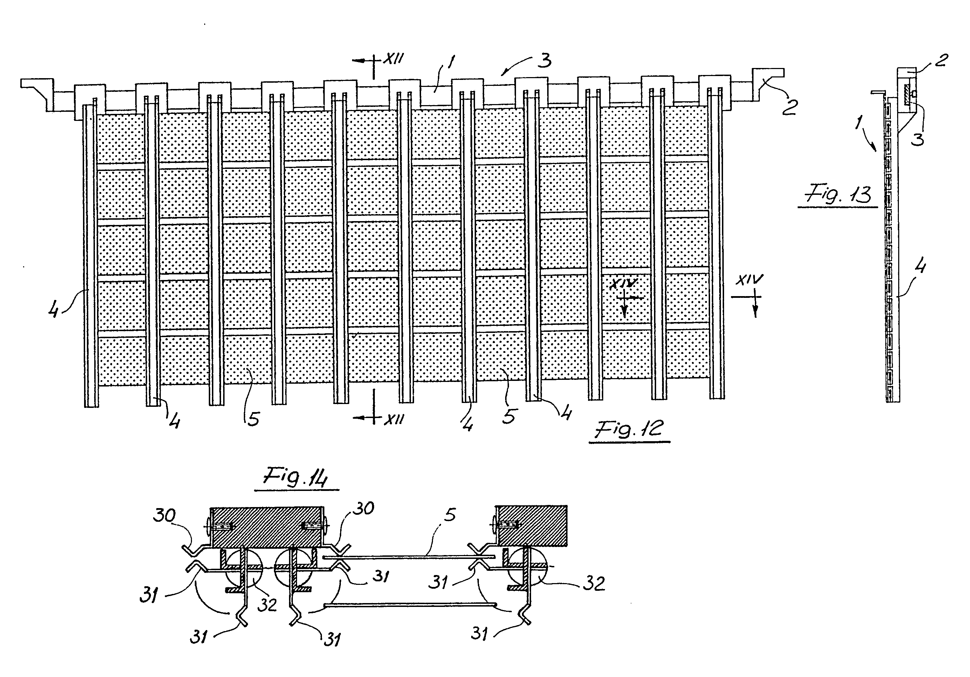

In the embodiment shown in figures 12 to 14,the cards 5 can be assembled at the front portion of the frame.

In this embodiment,on the facing edges of the rods 4,there are provided fixed contact elements, indicated at 30,which clamp the card 5,in cooperation with movable contact elements 31,which are supported by vertical bars 32 able of rotating about their axes so as to open the contacts thereby moving away the movable contacts from the fixed contacts.

This embodiment,as already disclosed, affords the possibility of removing the cards from the front portion of the frame.

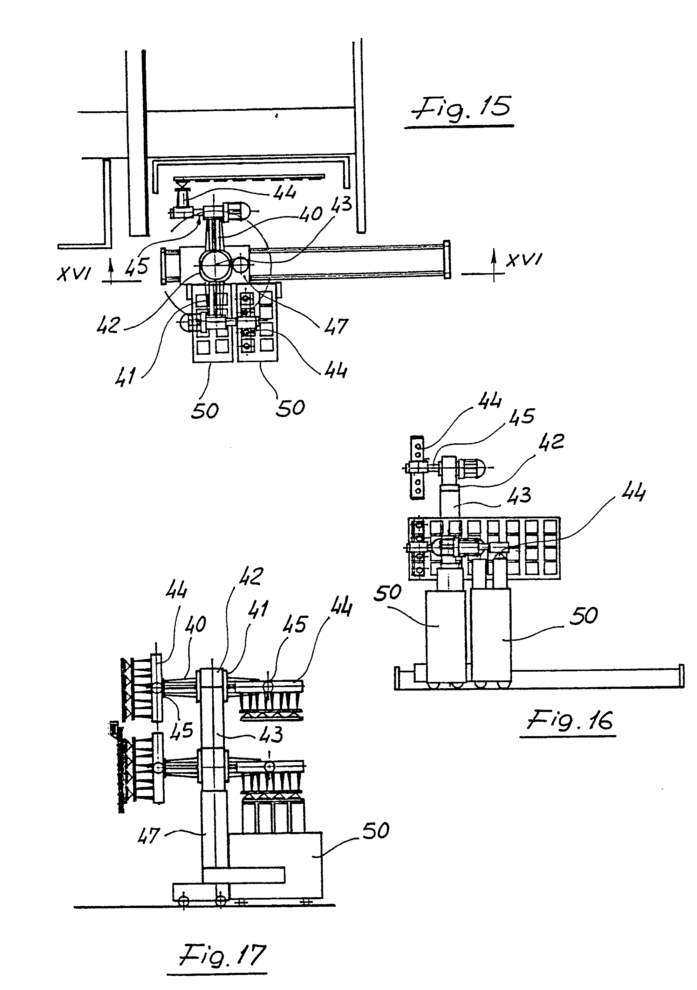

With reference to figures 15 to 17,a card handling apparatus is herein schematically shown, for loading and unloading the cards,which substantially comprises a pair of opposite arms 40 and 41 which extend from a sleeve 42,said sleeve being coupled to one end of a upright adapted to be vertically displaced and indicated at 43.

At the ends of the arms 42 there are provided sucker bearing elements,indicated at 44,and coupled to said arms so as to be able of rotating through 90° about an axis 45 perpendicular to the

The sucker bearing elements 44 are provided with a driving element for driving said sucker bearing elements 44 as desired.

The upright 43 is supported by a carriage 47, which can be displaced from the zone thereat there are arranged the frames 1 to the zone thereat the card supporting carriages are arranged,said carriage being indicated at 50.

The upwardly displacement is carried out in an automatic way,by removing the cards from the supporting frame 1 and rotating the upright 43 about its axis,so as to arrange on the supporting frames 1 new cards,while the removed cards are deposited on the carriage.

In order to carry out these operations, the sucker bearing elements are rotated through 90° about their axes,to be displaced from the vertical arrangement to the horizontal arrangement and/or viceversa.

From the above disclosure it should be apparent that the invention fully achieves the intended task and objects.

In particular,it should be pointed out that a card holding frame has been provided which affords the possibility of carrying out,in a completely automatic way,all of the card handling operations on the cards to be processed.

While the invention has been disclosed and illustrated with reference to preferred embodiments thereof,it should be apparent that the disclosed embodiments are susceptible to several modifications and variations,all coming within the spirit and scope of the appended claims.

## Claims

1- An automatically loaded/unloaded card holding frame,with resilient card restraining means,characterized in that said frame comprises a pair of supporting elements,coupled to one another by a presettable length bar,therewith a plurality of adjoining rods are associated,said rods being provided,on mutually facing edges,with resilient means adapted to be engaged with edge portions of said cards for removably holding said cards.

2- A card holding frame,according to the preceding claim,characterized in that said resilient means consist of plate springs defining a base adapted to be coupled to said rods and a pair of opposite ear elements projecting from said base and defining the card engaging zone.

3- A card holding frame,according to the preceding claims,characterized in that said plate springs are coupled to said rods through resilient contact elements adapted to be engaged in bushes associated with said rods.

4- A card holding frame according to one or more of the preceding claims,characterized in that between said plate spring and said bushes,about said resilient contact elements,there are arranged resilient spacer elements.

5- A card holding frame,according to one or more of the preceding claims,characterized in that said resilient means consist of loop springs coupled,at one end thereof,to said rods through locking means and adapted to be engaged,at the other end thereof,with a sliding edge defined by said rods,said loop springs engaging with said cards at their middle portion.

6- A card holding frame,according to one or more of the preceding claims,characterized in that said frame comprises guiding edges defined on said rods for the insertion of said cards along a vertical plane.

7- A card holding frame,according to one or more of the preceding claims,characterized in that said frame comprises, on the opposite edges of said rods,fixed contact elements therewith movable contact elements are engaged,said movable contact elements extending from rotatable vertical bars or rods adapted to open or close said contact elements to clamp or release said cards.

8- An apparatus for loading and unloading cards on/from a card holding frame according to any of the preceding claims,characterized in that it comprises a pair of opposite arms, extending from a sleeve associated with the top end of a vertically displaceable upright,said arms supporting,at their free ends,sucker bearing elements.

9- An apparatus according to the preceding claim, characterized in that said sucker bearing elements are able of rotating,with respect to said arms,about an axis which is substantially perpendicular to said arms.

10-An automatically loaded/unloaded holding frame with means for resiliently restraining or holding said cards,and card loading and unloading apparatus according to the preceding claims and substantially as broadly disclosed and illustrated for the intended task and objects.

Fig.1

Fig.2

Fig.3

Fig.4

Fig.5

Fig.6

VIII

3

2

2

1

5 4 4

VIII

*Fig. 7*

25

1

5

5

20

*Fig. 8*

25

25

21

20

22

*Fig. 9*

*Fig. 10*

25

20 a

20

22

*Fig. 11*

17

21

4

20

EP 0 328 853 A2

Fig. 13

Fig. 12

Fig. 14

EP 0 328 853 A2

Fig. 15

Fig. 16

Fig. 17